# EUROPEAN PATENT SPECIFICATION

(11) **EP 2 859 394 B1**
(45) Date of publication and mention of the grant of the patent: **30.05.2018**
(21) Application number: 13804751.9
(22) Date of filing: 13.06.2013
(51) Int. Cl.: G02B 6/42, H01S 5/022, H01S 5/00, H01S 5/183

(54) **TSV SUBSTRATE WITH MIRROR AND ITS APPLICATION IN HIGH-SPEED OPTOELECTRONIC PACKAGING**
TSV-SUBSTRAT MIT SPIEGEL UND DESSEN ANWENDUNG IN EINER OPTOELEKTRONISCHEN HOCHGESCHWINDIGKEITSVERPACKUNG
SUBSTRAT À TROUS D'INTERCONNEXION À TRAVERS LE SILICIUM DOTÉ D'UN MIROIR ET SON APPLICATION DANS UNE MISE EN BOÎTIER OPTOÉLECTRONIQUE À GRANDE VITESSE

(30) Priority: 12.06.2012 US 201213494692
(43) Date of publication of application: 15.04.2015
(73) Proprietor: Huawei Technologies Co., Ltd., Longgang District Shenzhen, Guangdong 518129 (CN)
(72) Inventor: YU, Fei, Santa Clara, California 95050 (US); DENG, Qi, San Jose, California 95129 (US)
(74) Representative: Gill Jennings & Every LLP
(86) International application number: PCT/CN2013/077188
(87) International publication number: WO 2013/185619

(56) References cited:
- CN-A- 1 601 313
- DE-A1- 3 543 558
- JP-A- 2006 003 818
- JP-A- 2006 003 818
- US-A1- 2004 017 977
- US-A1- 2004 223 680
- US-A1- 2004 234 210
- US-A1- 2011 026 875

## Description

### FIELD OF INVENTION

This disclosure is generally related to optoelectronic packaging. More specifically, this disclosure is related to an apparatus and a method for using a TSV substrate having a mirror facet in high-speed optoelectronic packaging.

### BACKGROUND

The increased demand for larger bandwidth in optical communications has driven the increased integration of optical and electrical devices in optoelectronic modules. These new modules require high-speed electrical interconnects and effective optical guiding. As the signal rate reaches 10 Gbps and beyond, traditional wire-bonding technology where metal wires are used to connect an integrated circuit (IC) chip or an optical chip (such as a laser diode or a light detector) to a printed circuit board (PCB) is no longer adequate.

US 2011/0026875 A1 and JP 2006-3818 A disclose alternative optical interconnect devices.

### SUMMARY

According to a first embodiment, there is provided a packaged optoelectronic module, comprising:
a photonic chip having a top surface; and
a first substrate that includes a plurality of vertical interconnect accesses, vias, and a reflective surface, wherein the photonic chip is flip-chip bonded to the first substrate with the top surface facing the first substrate, wherein the vias facilitate electrical connections to the top surface, and wherein the reflective surface forms an angle with the top surface, thereby enabling optical coupling between the top surface and an optical fiber placed in a direction that is substantially parallel to the top surface;
further comprising a second substrate situated below the first substrate, wherein the first substrate is bonded to the second substrate via the vias.

According to a second embodiment, there is provided a method for packaging an optoelectronic module that comprises a photonic chip, the method comprising:
flip-chip bonding the photonic chip to a first substrate;
wherein the first substrate includes a plurality of vias and a reflective surface, wherein the vias facilitate electrical connections to a top surface of the photonic chip, and wherein the reflective surface forms an angle with the top surface, thereby enabling optical coupling between the top surface and an optical fiber placed in a direction that is substantially parallel to the top surface;
bonding the first substrate to a second substrate via the vias.

### BRIEF DESCRIPTION OF THE DRAWINGS

FIG. 1 presents a diagram illustrating an exemplary packaging configuration where a photonic chip is flip-chip bonded to a through-silicon via (TSV) substrate, in accordance with an embodiment of the present invention.
FIG. 2 presents a diagram illustrating an exemplary packaged optoelectronic device that includes an electronic die and a photonic die, in accordance with an embodiment of the present invention.
FIG. 3 presents a diagram illustrating an exemplary packaged optoelectronic device that includes an electronic die and a photonic die, in accordance with an embodiment of the present invention.
FIG. 4 presents an exemplary optoelectronic module coupled to a fiber array, in accordance with an embodiment of the present invention.

### DETAILED DESCRIPTION

The following description is presented to enable any person skilled in the art to make and use the embodiments, and is provided in the context of a particular application and its requirements. Various modifications to the disclosed embodiments will be readily apparent to those skilled in the art, and the general principles defined herein may be applied to other embodiments and applications without departing from the spirit and scope of the present disclosure. Thus, the present invention is not limited to the embodiments shown, but is to be accorded the widest scope consistent with the principles and features disclosed herein.

### Overview

Embodiments of the present invention provide an apparatus and a method for high-speed optoelectronic packaging. A flip-chip bonding method is used to bond a photonic die and an electronic die onto a common substrate. In addition, a through-silicon via (TSV) substrate with a mirror facet is used to guide light and enable electrical interconnection between the photonic die and the electronic die.

In this disclosure, the terms "chip" and "die" are used interchangeably to describe an integrated optical or electronic circuit on a diced semiconductor wafer. A packaged optoelectronic device or module may include multiple chips or dies enclosed inside a single housing.

### High-Speed Packaging Module

Flip-chip bonding technology has been widely used in the packaging of high-speed IC chips. During packaging, the chips are flipped over to have their topsides facing down, and chip pads on the topside of the chips are aligned with matching connectors on the substrate. Previously deposited solder bumps/dots bond the chips to the PCB substrate, and transmission lines provide low-parasitic, high-speed electrical interconnects. Compared with traditional wire bonding technology, flip-chip bonding technology provides smaller package sizes, better heat conduction, and higher signal speeds. These advantages also make flip-chip bonding attractive for the packaging of photonic chips. However, there are challenges in applying flip-chip bonding to the packaging of photonic chips. More particularly, for photonic chips with a light-emitting or -receiving top surface, having their topsides facing down makes guiding light a challenge. For example, top-emitting vertical-cavity surface-emitting laser (VCSEL) chips often have their light-emitting surface on the same side of the electrodes, and the flip-chip packaging will result in the light-emitting surface facing the substrate. Similarly, flip-chip packaging of photo diodes generally results in the light-receiving surface facing the substrate.

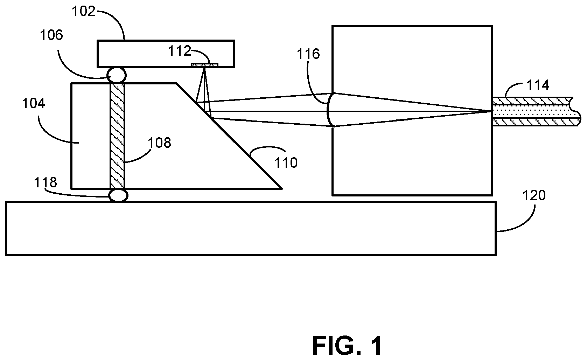

Because the packaging of photonic chips often involves coupling light to or from an optical fiber (or a ribbon of fibers), the downward configuration of the light-emitting/receiving surface presents a challenge. For example, light emitted from the photonic chip is obstructed by the substrate. To solve this problem, embodiments of the present invention implement a TSV substrate with a mirror facet. FIG. 1 presents a diagram illustrating an exemplary packaging configuration where a photonic chip is flip-chip bonded to a through-silicon via (TSV) substrate, in accordance with an embodiment of the present invention.

In FIG. 1, a photonic chip 102 is flip-chip bonded to a TSV substrate 104 via previously deposited solder bumps, such as a solder bump 106. TSV substrate 104 includes a number of vias, such as a via 108, and a reflecting mirror facet 110. TSV substrate 104 is further bonded to a substrate 120, such as a PCB, via its vias and corresponding solder bumps/balls, such as a solder bump 118.

Photonic chip 102 can be a light-emitting device (such as a VCSEL), a light-receiving device (such as a photo detector), or other devices that interact with light. Reflecting mirror facet 110 forms an angle with a light-emitting/receiving surface 112 of photonic chip 102, thus changing the direction of the light emitted from photonic chip 102. In one embodiment, this angle is approximately 45°. Consequently, reflecting mirror facet 110 can change the direction of the light emitted from photonic chip 102 by 90°. More specifically, the downwardly directed light emitted from light-emitting/receiving surface 112 becomes horizontally oriented after it reflects off reflecting mirror facet 110. Reflecting mirror facet 110 can be a cleaved facet or an etched facet. The horizontally oriented light can be coupled to the core of an optical fiber 114 (which can be a single mode or multimode fiber) via a focusing lens 116. Similarly, if photonic chip 102 is a photo detector, light coming from optical fiber 114 can be coupled to light-emitting/receiving surface 112 via focusing lens 116 and reflecting mirror facet 110.

Note that angled reflecting mirror facet 110 on TSV substrate 104 and a focusing lens enable optical coupling between a flip-chip bonded photonic chip and an optical fiber. In addition to optical coupling to a fiber, it is also essential to provide electrical connections (either for supplying power or for extracting signals) to the photonic chip. In embodiments of the present invention, electrical connections from substrate 120 to photonic chip 102 are established using vias (such as via 108) within TSV substrate 104. More specifically, an electronic signal pad on top of photonic chip 102 can be connected to a corresponding metal trace on substrate 120 through a metal (such as Cu) pillar filled in a respective via within TSV substrate 104.

Today's high-speed optoelectronic modules often require electronic components and photonic components to be packaged together, sharing a common substrate. For example, inside the package of a typical high-speed laser, one can find a laser chip and its driver (which provides power and control to the laser chip), both of which are bonded to a common substrate, and metal traces deposited on the common substrate provide high-speed interconnects. Similarly, a packaged high-speed photo detector often includes a detector chip and a preamplifier, both are bonded to a common substrate. To reduce parasitics, in embodiments of the present invention, the electrical chips are flip-chip bonded to the common substrate.

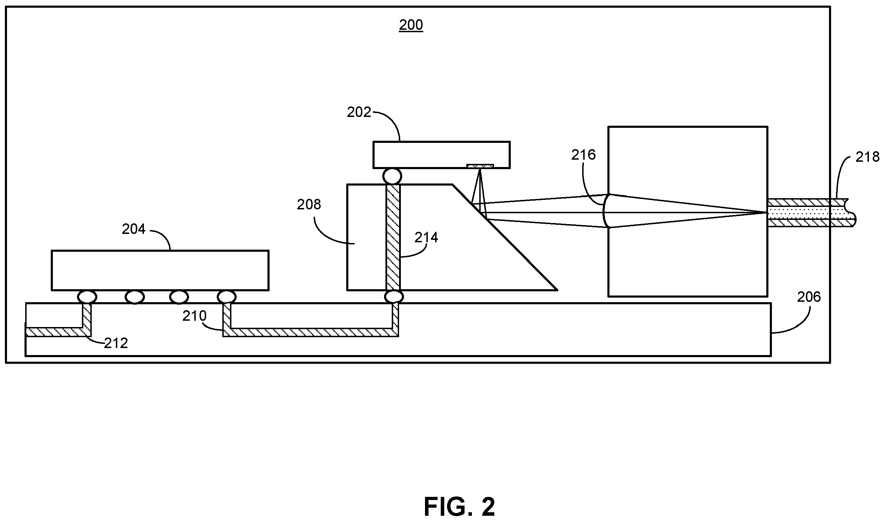

FIG. 2 presents a diagram illustrating an exemplary packaged optoelectronic device that includes an electronic die and a photonic die, in accordance with an embodiment of the present invention. In FIG. 2, packaged optoelectronic device 200 includes a photonic chip 202 and an electronic chip 204. Electronic chip 204 is flip-chip bonded to a common substrate 206, which can be a substrate made of organic or ceramic materials. In one embodiment, common substrate 206 includes a PCB. Photonic chip 202 is flip-chip bonded to a TSV substrate 208, which is also mounted on the surface of common substrate 206. In one embodiment, solder bumps are used to bond TSV substrate 208 to common substrate 206. Electrical connections, including connections between photonic chip 202 and electronic chip 204 and connections to any external circuitry, are provided by metal traces (such as a metal traces 210 and 212) on common substrate 206 and metal pillars filled in the vias (such as a via 214) within TSV substrate 208.

TSV substrate 208 includes an angled facet, which causes light emitted from photonic chip 202 to change its direction. In one embodiment, the downwardly directed light reflects off the angled facet to become horizontally directed. The horizontally directed light is then coupled to a fiber pigtail 218 via a focusing lens 216. Similarly, light originating from fiber 218 can be coupled to photonic chip 202 via focusing lens 216 and the angled facet of TSV substrate 208.

Note that, compared with traditional wire-bonding technology, flip-chip bonding of the photonic dies and the electronic dies onto a common substrate not only reduces parasitics caused by wires, which improves the high-speed performance of the device, but also improves heat dissipation of the device.

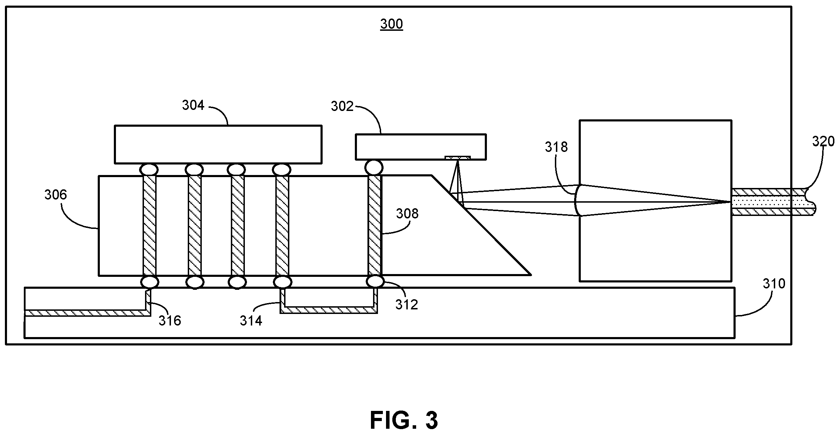

In an alternative embodiment, the electronic chips, similarly to the photonic chips, are also flip-chip bonded to the TSV substrate, and are electrically coupled to the underlying substrate (such as a PCB) through metal pillars filled in the vias of the TSV substrate. FIG. 3 presents a diagram illustrating an exemplary packaged optoelectronic device that includes an electronic die and a photonic die, in accordance with an embodiment of the present invention.

In FIG. 3, photonic chip 302 and electronic chip 304 are flip-chip bonded to a TSV substrate 306, which includes a number of vias, such as a via 308. TSV substrate 306 is bonded to a supporting substrate 310 through the vias and a number of corresponding solder balls, such as a solder ball 312. Electrical connections, including connections between photonic chip 302 and electronic chip 304 and connections to any external circuitry, are provided by metal traces (such as metal traces 314 and 316) on supporting substrate 310 and metal pillars filled in the vias of TSV substrate 306.

TSV substrate 306 includes an angled facet. Light emitted from the top surface of photonic chip 302 reflects off the angled facet and changes direction. In one embodiment, the downwardly directed light from photonic chip 302 becomes horizontally directed. The horizontally directed light is then coupled to a fiber pigtail 320 via a focusing lens 318. Similarly, light originating from fiber 320 can be coupled to photonic chip 302 via focusing lens 318 and the angled facet of TSV substrate 306.

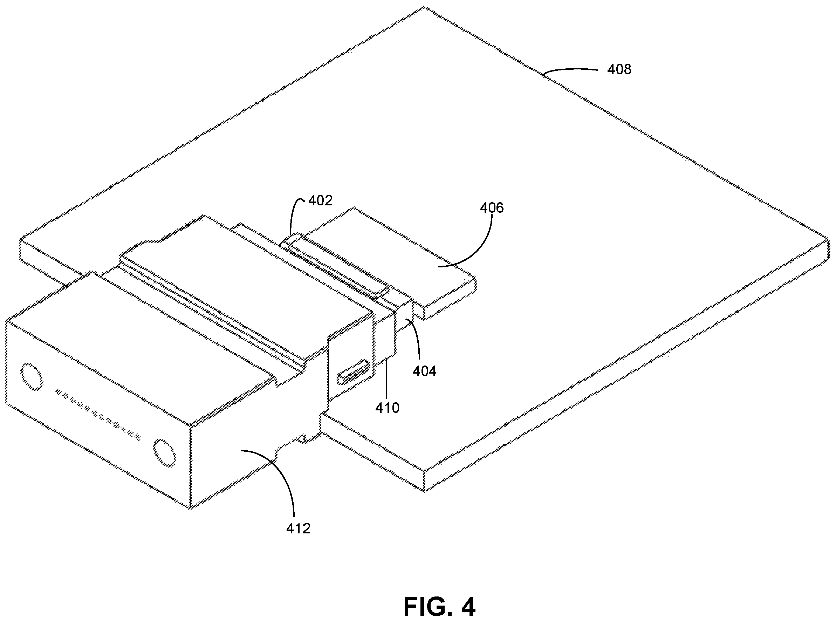

In FIGs. 2 and 3, the photonic chip includes a single light-emitting or light-receiving device that is optically coupled to a single fiber; however, in some embodiments, the photonic chip may include an array of devices, such as a VCSEL array or a photo detector array, coupled to an array of optical fibers. FIG. 4 presents an exemplary optoelectronic module coupled to a fiber array, in accordance with an embodiment of the present invention.

In FIG. 4, a photonic die 402 that includes an array of light-emitting or -receiving devices is flip-chip bonded to a TSV substrate 404, which includes an angled light-reflecting facet and a number of vias. TSV substrate 404 and an electronic die 406 are both flip-chip bonded to a common substrate 408. Electrical connections between photonic die 402 and electronic die 406, as well as electrical connections to external circuitries are provided by metal pillars (not shown in FIG. 4) in the vias of TSV substrate 404 and metal traces (not shown in FIG. 4) on top of common substrate 408. Light generated by the light-emitting array on photonic die 402 reflects off the angled facet of TSV substrate 404, changes its original downward direction to a horizontal direction, and is coupled to a fiber array 412 via a focusing lens 410. Note that, in order to focus light from the light-emitting array, focusing lens 410 may be a cylindrical lens. Fiber array 412 can be a 1-D fiber ribbon or a 2-D fiber array. Similarly, light originating from fiber array 412 can be coupled to corresponding light-receiving devices on photonic die 402 via focusing lens 410 and the angled facet of TSV substrate.

Embodiments of the present invention provide a novel packaging solution for integrated optoelectronic devices. The flip-chip bonding of photonic and electronic components eliminates massive bonding wires used in conventional wire-bonding technologies, thus significantly improving the high-speed performance of the packaged device. Additional advantages include reduced size (thus reduced footprint) and better heat dissipation, thus making this packaging solution suitable for high-speed (10 GHz and beyond) parallel optical engines (POEs). Note that such high-speed POEs provide solutions such as rack-to-rack, board-to-board, and chip-to-chip optical interconnections in the field of data communication and telecommunication.

Note that the examples shown in FIGs. 1-4 are for illustration purposes only and should not limit the scope of this disclosure. In general, embodiments of the present invention provide a packaging solution for optoelectronic devices where flip-chip bonding is used to bond the photonic and electronic dies to substrates. More specifically, the photonic die is flip-chip bonded to a substrate having an angled reflective surface and a number of through holes (vias). The through holes enable electrical connection to the photonic chip. The angled reflective surface changes the direction of light, thus enabling optical coupling between the top surface of the flip-chip-bonded photonic chip and optical fibers placed in a direction that is substantially parallel to the top surface of the photonic chip. The substrate with the through holes and the angled facet can be any type of substrate. In one embodiment, the substrate is a silicon substrate.

The foregoing descriptions of various embodiments have been presented only for purposes of illustration and description. They are not intended to be exhaustive or to limit the present invention to the forms disclosed. Accordingly, many modifications and variations will be apparent to practitioners skilled in the art. Additionally, the above disclosure is not intended to limit the present invention.

## Claims

1. A packaged optoelectronic module, comprising:
a photonic chip (102) having a top surface;
**characterized in that** the packaged optoelectric module further comprises:
a first substrate (104) that includes a plurality of vertical interconnect accesses, vias, (108) and a reflective surface (110), wherein the photonic chip is flip-chip bonded to the first substrate with the top surface facing the first substrate, wherein the vias facilitate electrical connections to the top surface, and wherein the reflective surface forms an angle with the top surface, thereby enabling optical coupling between the top surface and an optical fiber placed in a direction that is substantially parallel to the top surface;
further comprising a second substrate (120) situated below the first substrate, wherein the first substrate is bonded to the second substrate via the vias.

2. The packaged optoelectronic module of claim 1, wherein the first substrate is a through silicon via (TSV) substrate.

3. The packaged optoelectronic module of claim 1, wherein the photonic chip includes at least one of:
a vertical-cavity surface-emitting laser, VCSEL, and
a photo detector.

4. The packaged optoelectronic module of claim 1, further comprising an electronic chip, wherein the electronic chip is electrically coupled to the photonic chip using metal traces on the second substrate.

5. The packaged optoelectronic module of claim 1, wherein the second substrate includes one of:
a ceramic substrate, and
an organic substrate.

6. The packaged optoelectronic module of claim 1, wherein the angle between the reflective surface and the top surface of the photonic chip is approximately 45°.

7. A method for packaging an optoelectronic module that comprises a photonic chip, the method comprising:
flip-chip bonding the photonic chip (102) to a first substrate (104);
**characterized in that**:
the first substrate includes a plurality of vias (108) and a reflective surface (110), wherein the vias facilitate electrical connections to a top surface of the photonic chip, and wherein the reflective surface forms an angle with the top surface, thereby enabling optical coupling between the top surface and an optical fiber placed in a direction that is substantially parallel to the top surface;
bonding the first substrate to a second substrate (120) via the vias.

8. The method of claim 7, wherein the first substrate is a through silicon via, TSV, substrate.

9. The method of claim 7, wherein the photonic chip includes at least one of:
a vertical-cavity surface-emitting laser, VCSEL, and
a photo detector.

10. The method of claim 7, further comprising flip-chip bonding an electronic chip to the second substrate, wherein the electronic chip is electrically coupled to the photonic chip using metal traces on the second substrate.

11. The method of claim 7, further comprising flip-chip bonding an electronic chip to the first substrate, wherein the electronic chip is electrically coupled to the photonic chip using metal traces on the second substrate.

12. The method of claim 7, further comprising placing a focusing lens between the reflective surface and the optical fiber.

13. The method of claim 7, wherein the angle between the reflective surface and the top surface of the photonic chip is approximately 45°

## Patentansprüche

1. Integriertes Optoelektronikmodul, das Folgendes umfasst:
einen photonischen Chip (102), eine obere Oberfläche aufweisend;
**dadurch gekennzeichnet, dass** das integrierte Optoelektronikmodul ferner Folgendes umfasst:
ein erstes Substrat (104), das eine Vielzahl von vertikalen Verbindungkontaktlöchern bzw. Vias (108) und eine reflektierende Oberfläche (110) beinhaltet, wobei der photonische Chip mit dem ersten Substrat flip-chip-gebondet ist, wobei die obere Oberfläche dem ersten Substrat zugewandt ist, wobei die Vias elektrische Verbindungen mit der oberen Oberfläche vermitteln, und wobei die reflektierende Oberfläche einen Winkel mit der oberen Oberfläche bildet, wodurch optische Kopplung zwischen der oberen Oberfläche und einer Glasfaser ermöglicht wird, die in einer Richtung platziert ist, die im Wesentlichen parallel zur oberen Oberfläche ist;
ferner umfassend ein zweites Substrat (120), das sich unter dem ersten Substrat befindet, wobei das erste Substrat über die Vias mit dem zweiten Substrat gebondet ist.

2. Integriertes Optoelektronikmodul nach Anspruch 1, wobei das erste Substrat ein Durch-Silicium-Via-Substrat bzw. TSV-Substrat ist.

3. Integriertes Optoelektronikmodul nach Anspruch 1, wobei der photonische Chip mindestens einen der Folgenden beinhaltet:
einen "Vertical-Cavity-Surface-Emitting-Laser" bzw. VCSEL und
einen Photodetektor.

4. Integriertes Optoelektronikmodul nach Anspruch 1, ferner umfassend einen elektronischen Chip, wobei der elektronische Chip unter Verwendung von Metallleiterbahnen auf dem zweiten Substrat elektrisch mit dem photonischen Chip gekoppelt ist.

5. Integriertes Optoelektronikmodul nach Anspruch 1, wobei das zweite Substrat eines der Folgenden beinhaltet:
ein keramisches Substrat und
ein organisches Substrat.

6. Integriertes Optoelektronikmodul nach Anspruch 1, wobei der Winkel zwischen der reflektierenden Oberfläche und der oberen Oberfläche des photonischen Chips ungefähr 45° beträgt.

7. Verfahren zum Integrieren eines Optoelektronikmoduls, das einen photonischen Chip umfasst, wobei das Verfahren die folgenden Schritte umfasst:
Flip-Chip-Bonden des photonischen Chips (102) an ein erstes Substrat (104);
**dadurch gekennzeichnet, dass**
das erste Substrat eine Vielzahl von Vias (108) und eine reflektierende Oberfläche (110) beinhaltet, wobei die Vias elektrische Verbindungen mit einer oberen Oberfläche des photonischen Chips vermitteln, und wobei die reflektierende Oberfläche einen Winkel mit der oberen Oberfläche bildet, wodurch optische Kopplung zwischen der oberen Oberfläche und einer Glasfaser ermöglicht wird, die in einer Richtung platziert ist, die im Wesentlichen parallel zur oberen Oberfläche ist; Bonden des ersten Substrats über die Vias an ein zweites Substrat (120).

8. Verfahren nach Anspruch 7, wobei das erste Substrat ein Durch-Silicium-Via-Substrat bzw. TSV-Substrat ist.

9. Verfahren nach Anspruch 7, wobei der photonische Chip mindestens einen der Folgenden beinhaltet:
einen "Vertical-Cavity-Surface-Emitting-Laser" bzw. VCSEL und
einen Photodetektor.

10. Verfahren nach Anspruch 7, ferner umfassend Flip-Chip-Bonden eines elektronischen Chips an das zweite Substrat, wobei der elektronische Chip unter Verwendung von Metallleiterbahnen auf dem zweiten Substrat elektrisch mit dem photonischen Chip gekoppelt wird.

11. Verfahren nach Anspruch 7, ferner umfassend Flip-Chip-Bonden eines elektronischen Chips an das erste Substrat, wobei der elektronische Chip unter Verwendung von Metallleiterbahnen auf dem zweiten Substrat elektrisch mit dem photonischen Chip gekoppelt wird.

12. Verfahren nach Anspruch 7, ferner umfassend Platzieren einer Fokussierungslinse zwischen der reflektierenden Oberfläche und der Glasfaser.

13. Verfahren nach Anspruch 7, wobei der Winkel zwischen der reflektierenden Oberfläche und der oberen Oberfläche des photonischen Chips ungefähr 45° beträgt.

## Revendications

1. Module optoélectronique encapsulé, comprenant :
une puce photonique (102) ayant une surface supérieure ;
**caractérisé en ce que** le module optoélectrique encapsulé comprend en outre :
un premier substrat (104) qui comprend une pluralité d'accès d'interconnexion verticaux, des trous d'interconnexion, (108) et une surface réfléchissante (110), la puce photonique étant collée, puce retournée, au premier substrat, avec la surface supérieure faisant face au premier substrat, les trous d'interconnexion facilitant des connexions électriques à la surface supérieure, et la surface réfléchissante formant un angle avec la surface supérieure, permettant ainsi un couplage optique entre la surface supérieure et une fibre optique placée dans une direction qui est sensiblement parallèle à la surface supérieure ;
comprenant en outre, un second substrat (120) situé en-dessous du premier substrat, le premier substrat étant lié au second substrat par l'intermédiaire des trous d'interconnexion.

2. Module optoélectronique encapsulé selon la revendication 1, le premier substrat étant un substrat de trous d'interconnexion traversant le silicium (TSV).

3. Module optoélectronique encapsulé selon la revendication 1, la puce photonique comprenant au moins un élément parmi :
un laser à cavité verticale à émission de surface, VCSEL, et
un photodétecteur.

4. Module optoélectronique encapsulé selon la revendication 1, comprenant en outre une puce électronique, la puce électronique étant électriquement couplée à la puce photonique à l'aide de traces métalliques sur le second substrat.

5. Module optoélectronique encapsulé selon la revendication 1, le second substrat comprenant un élément parmi :
un substrat en céramique, et
un substrat organique.

6. Module optoélectronique encapsulé selon la revendication 1, l'angle entre la surface réfléchissante et la surface supérieure de la puce photonique étant d'environ 45°.

7. Procédé d'encapsulation d'un module optoélectronique qui comprend une puce photonique, le procédé comprenant :
le collage, puce retournée, de la puce photonique (102) à un premier substrat (104) ;
**caractérisé en ce que** :
le premier substrat comprend une pluralité de trous d'interconnexion (108) et une surface réfléchissante (110), les trous d'interconnexion facilitant des connexions électriques avec une surface supérieure de la puce photonique, et la surface réfléchissante formant un angle avec la surface supérieure, permettant ainsi un couplage optique entre la surface supérieure et une fibre optique placée dans une direction qui est sensiblement parallèle à la surface supérieure ;
la liaison du premier substrat à un second substrat (120) par l'intermédiaire des trous d'interconnexion.

8. Procédé selon la revendication 7, le premier substrat étant un substrat de trous d'interconnexion traversant le silicium (TSV).

9. Procédé selon la revendication 7, la puce photonique comprenant au moins un élément parmi :
un laser à cavité verticale à émission de surface, VCSEL, et
un photodétecteur.

10. Procédé selon la revendication 7, comprenant en outre le collage, puce retournée, d'une puce électronique au second substrat, la puce électronique étant électriquement couplée à la puce photonique à l'aide de traces métalliques sur le second substrat.

11. Procédé selon la revendication 7, comprenant en outre le collage, puce retournée, d'une puce électronique au premier substrat, la puce électronique étant électriquement couplée à la puce photonique à l'aide de traces métalliques sur le second substrat.

12. Procédé selon la revendication 7, comprenant en outre le placement d'une lentille de focalisation entre la surface réfléchissante et la fibre optique.

13. Procédé selon la revendication 7, l'angle entre la surface réfléchissante et la surface supérieure de la puce photonique étant d'environ 45°.
